# EUROPEAN PATENT APPLICATION

(11) **EP 4 848 334 A1**
(43) Date of publication of application: **02.12.2026**
(21) Application number: 24920249.0
(22) Date of filing: 30.08.2024
(51) Int. Cl.: H01L 21/316

(54) **HAFNIUM OXIDE FILM MODIFICATION METHOD AND NONVOLATILE MEMORY DEVICE**

(30) Priority: 23.01.2024 JP 2024007913
(71) Applicant: The Japan Steel Works, Ltd., Tokyo 141-0032 (JP)
(72) Inventor: IMAMURA Hiroaki, Tokyo 141-0032 (JP); JIN Yoshito, Tokyo 141-0032 (JP)
(74) Representative: Simmons & Simmons LLP (Munich)
(86) International application number: PCT/JP2024/031233
(87) International publication number: WO 2025/158700

(57) **Abstract**

The present invention provides a hafnium oxide film modification method and the like capable of crystallizing (modifying) the film into an orthorhombic-phase (o-phase)-dominant ferroelectric hafnium oxide (film). The hafnium oxide film modification method comprises: a film formation step (S11) of forming an amorphous hafnium oxide film on a silicon substrate; and a crystallization step (S12) of irradiating the amorphous hafnium oxide film with pulsed laser light having a wavelength in the ultraviolet range so that the amorphous hafnium oxide film is modified into an o-phase-dominant hafnium oxide film and aggregation of the o-phase-dominant hafnium oxide film is prevented.

## Description

### Technical Field

The present disclosure relates to a method for modifying a hafnium oxide film and a nonvolatile memory device.

### Background Art

Crystallization processes in which a silicon substrate with a hafnium oxide film is annealed have been practiced. In addition to ordinary resistance heating, RTA (Rapid Thermal Annealing) and the like have also been used. An example of such annealing processes is disclosed, for example, in Patent Literature 1.

### Citation List

### Patent Literature

[Patent Literature 1] Japanese Unexamined Patent Application Publication No. 2023-135612

### Summary of Invention

### Technical Problem

However, in a hafnium oxide (film), which may contain a plurality of crystal phases, the paraelectric m-phase (monoclinic phase) is the most stable crystal phase, so that there is a problem that it is difficult to suppress the most stable m-phase and crystallize (modify) the hafnium oxide (film) into a hafnium oxide (film) mainly composed of a ferroelectric o-phase (orthorhombic phase) by the above-mentioned crystallization process.

Other problems (or objects) and novel features will become apparent from the descriptions in the specification of the present disclosure and the drawings attached thereto.

### Solution to Problem

A method for modifying a hafnium oxide film according to an embodiment includes: a film forming step of forming an amorphous hafnium oxide film over a silicon substrate; and a crystallization step of irradiating the amorphous hafnium oxide film with pulsed laser light whose wavelength is in an ultraviolet region in such a manner that the amorphous hafnium oxide film is modified into a hafnium oxide film mainly composed of an o-phase and agglomeration of the hafnium oxide film mainly composed of the o-phase does not occur. **Advantageous Effects of Invention**

According to the embodiment, it is possible to provide a method for modifying a hafnium oxide film, capable of crystallizing (modifying) a hafnium oxide (film) into a hafnium oxide (film) mainly composed of a ferroelectric o-phase, and provide a nonvolatile memory device.

### Brief Description of Drawings

Fig. 1 is a flowchart of a method for modifying a hafnium oxide film according to the present disclosure;
Fig. 2A is a schematic structural diagram of 1T1C (capacitor type);
Fig. 2B is a schematic structural diagram of 1T (transistor type);
Fig. 3 is a schematic diagram showing how an amorphous hafnium oxide film 20 is formed over a silicon substrate 10;
Fig. 4 is a schematic diagram showing how the hafnium oxide film 20 formed over the silicon substrate 10 is crystallized (modified);
Fig. 5A is a graph showing an X-ray diffraction pattern (results of Experiment 1);
Fig. 5B is a graph showing an X-ray diffraction pattern (results of Experiment 2);
Fig. 6 is a schematic diagram showing how the hafnium oxide film 20 formed over the silicon substrate 10 is crystallized (modified);
Fig. 7A is a graph showing an X-ray diffraction pattern (results of Experiment 3);
Fig. 7B is a graph showing an X-ray diffraction pattern (results of Experiment 4);
Fig. 8 is an SEM image of a hafnium oxide film photographed by a SEM;
Fig. 9A is a graph showing an X-ray diffraction pattern (results of Experiment 5);
Fig. 9B is a graph showing an X-ray diffraction pattern (results of Experiment 6);
Fig. 10 is an SEM image of a hafnium oxide film photographed by a SEM;
Fig. 11A shows a comparative example;
Fig. 11B shows an embodiment;
Fig. 12 is a schematic configurational diagram of a nonvolatile memory device M to which a hafnium oxide film 20_{T+K} modified by a method for modifying a hafnium oxide film according to an embodiment is applied; and
Fig. 13 is an example of a flowchart of a process for manufacturing a nonvolatile memory device M.

### Description of Embodiments

Specific embodiments will be described hereinafter in detail with reference to the drawings. However, the present disclosure is not limited to the embodiments shown below. Further, in order to clarify the explanation, the following description and the drawings are simplified as appropriate.

### <Outline of Method for Modifying Hafnium Oxide Film>

Firstly, an outline of a method for modifying a hafnium oxide film (hereinafter also referred to as a hafnium oxide film modifying method) according to the present disclosure will be described.

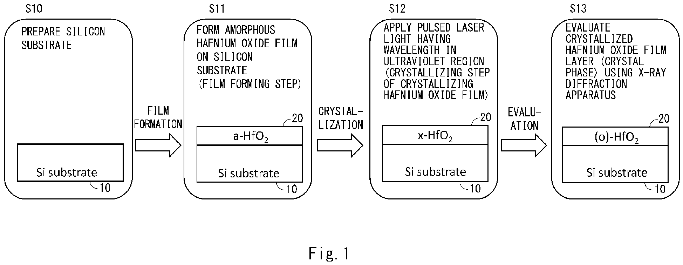

Fig. 1 is a flowchart of a hafnium oxide film modifying method according to the present disclosure.

As shown in Fig. 1, the hafnium oxide film modifying method according to the present disclosure includes preparing a silicon substrate 10 (Step S10), a film forming step of forming an amorphous hafnium oxide film 20 on the silicon substrate 10 (Step S11), and a crystallization step of irradiating the amorphous hafnium oxide film 20 with pulsed laser light whose wavelength is in an ultraviolet region (Step S12). In the crystallization step, the energy density, the wavelength, the pulse interval, and the pulse width of the pulsed laser light are selected so that the amorphous hafnium oxide film 20 is modified into a hafnium oxide film mainly composed of an o-phase and the agglomeration of the hafnium oxide film mainly composed of the o-phase (orthorhombic phase) does not occur.

According to the hafnium oxide film modifying method in accordance with the present disclosure, it is possible to crystallize (modify) the amorphous hafnium oxide film 20 formed over the silicon substrate 10 into a hafnium oxide film in which the most stable m-phase is suppressed, i.e., into a hafnium oxide film mainly composed of a ferroelectric o-phase.

It is possible to confirm that the amorphous hafnium oxide film has been crystalized (modified) into a hafnium oxide film in which the most stable m-phase is suppressed, i.e., into a hafnium oxide film mainly composed of a ferroelectric o-phase by evaluating the hafnium oxide film (crystal phase) crystallized in the step S12 using an X-ray diffraction apparatus (Step S13). Note that "a-HfO₂" in Fig. 1 represents the amorphous hafnium oxide film 20. "x-HfO₂" in Fig. 1 represents the crystallized hafnium oxide film 20. "(o)-HfO₂" in Fig. 1 represents the hafnium oxide film in which the most stable m-phase is suppressed, i.e., represents a hafnium oxide film mainly composed of a ferroelectric o-phase.

The hafnium oxide film, which has been crystallized (modified) by the hafnium oxide film modifying method according to the present disclosure and in which the most stable m-phase is suppressed, i.e., the hafnium oxide film mainly composed of a ferroelectric o-phase, can be applied to (i.e., used for) a nonvolatile memory device.

### <Background of Method for Forming Hafnium Oxide Film>

Next, the background of the method for forming a hafnium oxide film according to the present disclosure will be described.

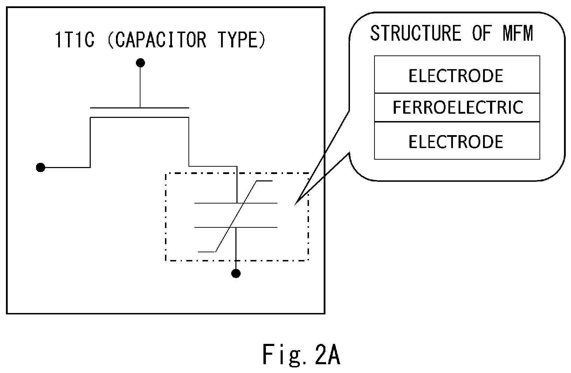

In the past, in the field of nonvolatile memory devices, PZT (lead zirconate titanate), SBT (strontium bismuthate tantalate), and the like have been used as ferroelectric materials and commercialized as the material of 1T1C (capacitor type). Fig. 2A is a schematic structural diagram of 1T1C (capacitor type).

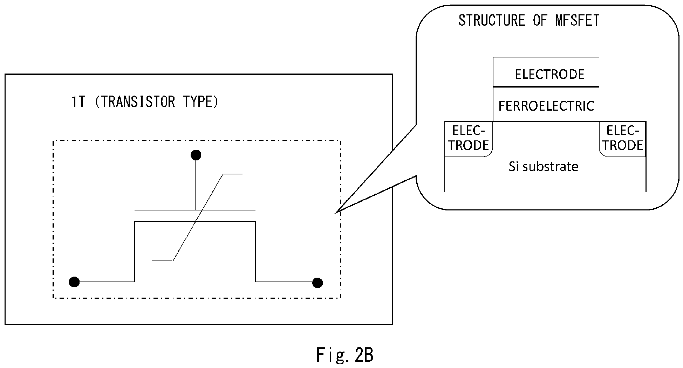

In contrast, the inventors of the present application have applied the above-described conventional ferroelectric material to 1T (transistor type) in order to increase the densification, and studied how to reduce the thickness of the conventional ferroelectric material. Fig. 2B is a schematic structural diagram of 1T (transistor type).

However, it has been known that when the aforementioned conventional ferroelectric material is applied to 1T (transistor type), there is a limit to the reduction of the thickness of the ferroelectric material, and that there is a problem in regard to the affinity with a silicon substrate.

Therefore, the inventors of the present application have studied, for the ferroelectric material for 1T (transistor type), the use of a hafnium oxide (HfO₂) which exhibits ferroelectricity when it is formed as an extremely thin film and of which the film can be directly formed over a silicon substrate.

However, in a hafnium oxide, which may contain a plurality of crystal phases, the paraelectric m-phase (monoclinic phase) is the most stable crystal phase, so that the inventors of the present application have studied a method for crystallizing a hafnium oxide in which the most stable m-phase is suppressed. The inventors of the present application have conducted a number of experiments in the course of the aforementioned study.

As a result, the inventors of the present application have found a method for crystallizing (modifying) an amorphous hafnium oxide film formed over a silicon substrate into a hafnium oxide film in which the most stable m-phase is suppressed, i.e., into a hafnium oxide film mainly composed of a ferroelectric o-phase (i.e., have found a method for forming a hafnium oxide film according to the present disclosure).

Experiments 1 to 6 which the inventors of the present application have carried out in order to obtain a method for forming a hafnium oxide film according to the present disclosure will be described hereinafter.

### <Experiment 1>

Experiment 1 was carried out under the conditions shown in Table 1 shown below.

**[Table 1]**

| | |
|---|---|
| Film Forming | Film Forming Apparatus: ALD Apparatus (Demonstration Machine) manufactured by JSW AFTY Corporation |
| | Film Forming Technique: thermal-ALD (thermal ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: XeCl Light Source |
| | Laser Wavelength: 308 nm |
| | Pulse Interval: 10 ms (100 Hz) |
| | Pulse Width (FWHM): Several Tens of Nanoseconds, |

Experiment 1 will be described hereinafter in detail.

### <Formation of Film in Experiment 1>

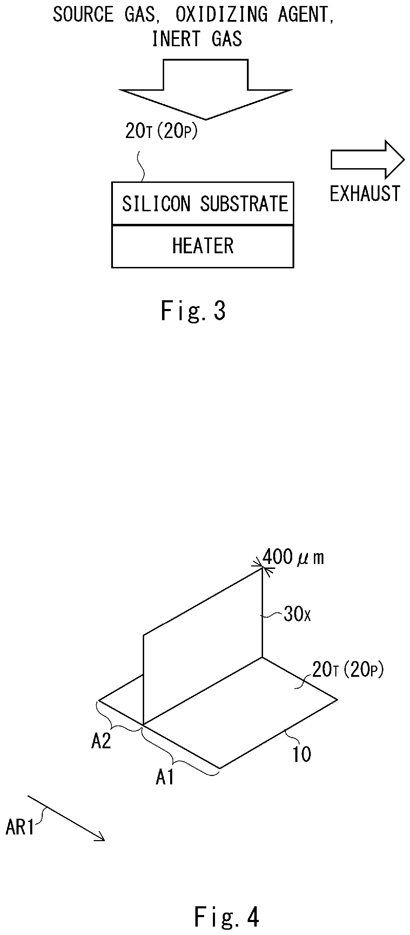

Fig. 3 is a schematic diagram showing how an amorphous hafnium oxide film 20 is formed over a silicon substrate 10.

In Experiment 1, an amorphous hafnium oxide film 20 was formed over a silicon substrate 10 by a thermal-ALD method using a film forming apparatus (ALD apparatus (demonstration machine) manufactured by JSW AFTY Corporation). ALD stands for Atomic Layer Deposition and is also called atomic layer deposition. Hereinafter, the amorphous hafnium oxide film 20 formed over the silicon substrate 10 by the thermal-ALD method will be referred to as a hafnium oxide film 20_{T}.

Specifically, as shown in Fig. 3, an extremely thin hafnium oxide film 20_{T} having a film thickness of 10 nm was formed over a silicon substrate 10, which had been heated to 120°C by a heater in advance, by bringing one of the surfaces of the silicon substrate 10 into contact with a flowing source gas, an oxidizing agent, and an inert gas. Note that tEMAH (Tetrakis(EthylMethylAmido)Hafnium) was used as the source gas; O₃ was used as the oxidizing agent; and N₂ was used as the inert gas.

### <Crystallization (Modifying) in Experiment 1>

Fig. 4 is a schematic diagram how the hafnium oxide film 20 formed over the silicon substrate 10 is crystallized (modified).

In Experiment 1, the hafnium oxide film 20_{T} formed over the silicon substrate 10 was irradiated with pulsed laser light 30_{X} whose wavelength is in an ultraviolet region by using a pulsed laser irradiation apparatus equipped with a XeCl light source (wavelength 308 nm) (excimer laser irradiation apparatus (demonstration machine) manufactured by JSW Aktina System Co., Ltd.). The pulsed laser light 30_{X} had a wavelength of 308 nm, a pulse interval of 10 ms (100 Hz), and a pulse width (FWHM) of several tens of nanoseconds, and the number of times of irradiation (number of shots) was 200 times (200 shots). In Experiment 1, the energy density of the pulsed laser light 30_{X} was changed to 170 mJ/cm², 220 mJ/cm², 270 mJ/cm², and 400 mJ/cm², and the pulsed laser light 30_{X} was applied 200 times (200 shots) with each of these energy densities.

Specifically, as shown in Fig. 4, the silicon substrate 10 (hafnium oxide film 20_{T}) which was being conveyed in a direction indicated by an arrow AR1 by a conveyance mechanism (not shown) was irradiated with pulsed laser light 30_{X} in a nitrogen atmosphere. The width (width in the conveying direction) of the pulsed laser light 30_{X} was about 400 µm (see Fig. 4). When doing so, the conveying speed of the silicon substrate 10 (hafnium oxide film 20_{T}) was set to 0.2 mm/s so that adjacent regions already irradiated with the pulsed laser light 30_{X} overlapped one another as the silicon substrate 10 (hafnium oxide film 20_{T}) was conveyed. Hereinafter, the hafnium oxide film 20_{T} which was formed over the silicon substrate 10 by the thermal-ALD method and irradiated with the pulsed laser light 30_{X} will be referred to as a hafnium oxide film 20_{T+X}. Note that in Fig. 4, the reference numeral A1 represents the region already irradiated with the pulsed laser light, and the reference numeral A2 represents a region which has not yet been irradiated with the pulsed laser light.

### <Results of Experiment 1>

Next, the results (evaluation results) of Experiment 1 will be described.

### <Evaluation by X-ray Diffraction Apparatus>

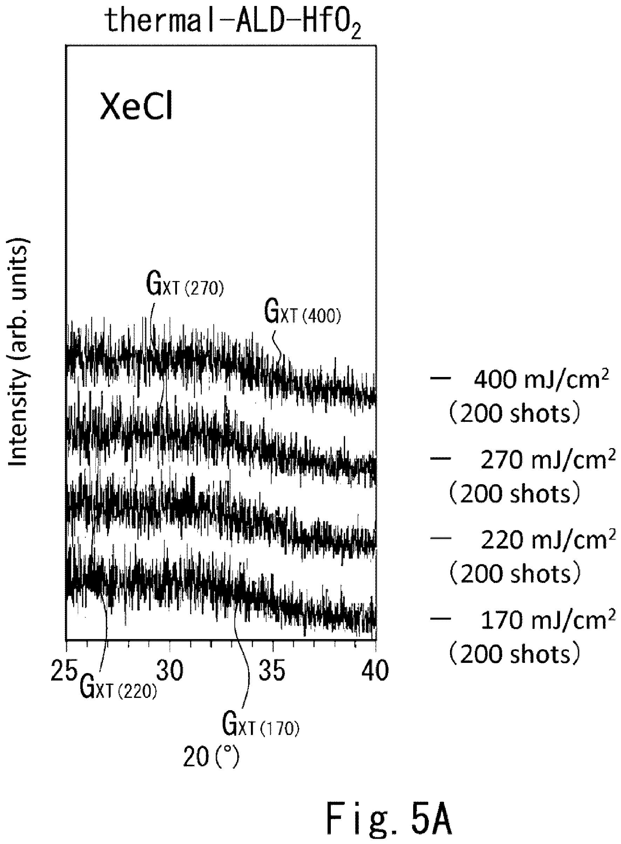

Fig. 5A is a graph showing an X-ray diffraction pattern (result of Experiment 1). In Fig. 5A, the reference numeral G_{XT(170)} represents a graph when the energy density was 170 mJ/cm². The reference numeral G_{XT(220)} represents a graph when the energy density was 220 mJ/cm². The reference numeral G_{XT(270)} represents a graph when the energy density was 270 mJ/cm². The reference numeral G_{XT(400)} represents a graph when the energy density was 400 mJ/cm².

As for the evaluation using an X-ray diffraction apparatus, the hafnium oxide film 20_{T+X} (crystal phase) which had been irradiated with the pulsed laser light 30_{X} as describe above was evaluated by using an X-ray diffraction apparatus (X-ray diffraction apparatus manufactured by Rigaku Holdings Corporation). The X-ray diffraction apparatus is also called XRD (X-ray diffraction). There are various measurement methods for the X-ray diffraction apparatus, and 2θ scanning of an asymmetric reflection measurement suitable for the evaluation of a thin film was carried out. The thin film method measurement is also called GI-XRD (Grazing Incidence XRD) because the thin film is evaluated at a minute incident angle. The conditions for the measurement by the X-ray diffraction apparatus is an incident angle ω being 0.4 deg (ω = 0.4 deg).

As a premise, if the crystallization of the hafnium oxide film in which the most stable m-phase is suppressed advances, i.e., if the amorphous hafnium oxide film (showing paraelectricity) formed over the silicon substrate 10 is modified into a hafnium oxide film mainly composed of an o-phase (showing ferroelectricity), the X-ray diffraction pattern of the modified hafnium oxide film obtained by the X-ray diffraction apparatus has a peak around 2θ, i.e., 30.35° (2θ = 30.35°).

Referring to Fig. 5A, it can be understood that there is no peak around 2θ, i.e., 30.35° (2θ = 30.35°) in any of the graphs G_{XT(170)}, G_{XT(220)}, G_{XT(270)}, and G_{XT(400)} in Experiment 1.

That is, it can be understood that the hafnium oxide film 20_{T} formed over the silicon substrate 10 cannot be crystallized (modified) into a hafnium oxide film in which the most stable m-phase is suppressed, i.e., into a hafnium oxide film mainly composed of a ferroelectric o-phase, in Experiment 1.

### <Experiment 2>

Experiment 2 was carried out under the conditions shown in Table 2 shown below.

**[Table 2]**

| | |
|---|---|
| Film Forming | Film Forming Apparatus: ALD Apparatus (Demonstration Machine) manufactured by JSW AFTY Corporation |
| | Film Forming Technique: plasma-ALD (plasma ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: XeCl Light Source |
| | Laser Wavelength: 308 nm |
| | Pulse Interval: 10 ms (100 Hz) |
| | Pulse Width (FWHM): Several Tens of Nanoseconds |

Experiment 2 will be described hereinafter in detail.

### <Formation of Film in Experiment 2>

In Experiment 2, an amorphous hafnium oxide film 20 was formed over a silicon substrate 10 by a plasma-ALD method using a film forming apparatus (ALD apparatus (demonstration machine) manufactured by JSW AFTY Corporation). Hereinafter, the amorphous hafnium oxide film 20 formed over the silicon substrate 10 by the plasma-ALD method will be referred to as a hafnium oxide film 20_{P}.

Specifically, similarly to Experiment 1 (see Fig. 3), an extremely thin hafnium oxide film 20_{P} having a film thickness of 10 nm was formed over a silicon substrate 10 (one of the surfaces), which had been heated to 120°C by a heater in advance, by bringing one of the surfaces of the silicon substrate 10 into contact with a flowing source gas, an oxidizing agent; and an inert gas. Note that tEMAH (Tetrakis(EthylMethylAmido)Hafnium) was used as the source gas; O₂ plasma was used as the oxidizing agent; and N₂ was used as the inert gas.

### <Crystallization (Modifying) in Experiment 2>

In Experiment 2, similarly to Experiment 1 (see Fig. 4), the hafnium oxide film 20_{P} formed over the silicon substrate 10 was irradiated with pulsed laser light 30_{X} whose wavelength is in an ultraviolet region by using a pulsed laser irradiation apparatus equipped with a XeCl light source (wavelength 308 nm) (excimer laser irradiation apparatus (demonstration machine) manufactured by JSW Aktina System Co., Ltd.). The pulsed laser light 30_{X} had a wavelength of 308 nm, a pulse interval of 10 ms (100 Hz), and a pulse width (FWHM) of several tens of nanoseconds, and the number of times of irradiation was 200 times (200 shots). In Experiment 2, the energy density of the pulsed laser light 30_{X} was changed to 170 mJ/cm²,(220 mJ/cm²,(270 mJ/cm², and(400 mJ/cm², and the pulsed laser light 30_{X} was applied 200 times (200 shots) with each of these energy densities.

Specifically, similarly to Experiment 1 (see Fig. 4), the silicon substrate 10 (hafnium oxide film 20_{P}) which was being conveyed in a direction indicated by an arrow AR1 by a conveyance mechanism (not shown) was irradiated with pulsed laser light 30_{X} in a nitrogen atmosphere. The width (width in the conveying direction) of the pulsed laser light 30_{X} was about 400 µm (see Fig. 4). When doing so, the conveying speed of the silicon substrate 10 (hafnium oxide film 20_{P}) was set to 0.2 mm/s so that adjacent regions already irradiated with the pulsed laser light 30_{X} overlapped one another as the silicon substrate 10 (hafnium oxide film 20_{P}) was conveyed. Hereinafter, the hafnium oxide film 20_{P} which was formed over the silicon substrate 10 by the plasma-ALD method and irradiated with the pulsed laser light 30_{X} will be referred to as a hafnium oxide film 20_{P+X}.

### <Results of Experiment 2>

Next, the results (evaluation results) of Experiment 2 will be described.

### <Evaluation by X-ray Diffraction Apparatus>

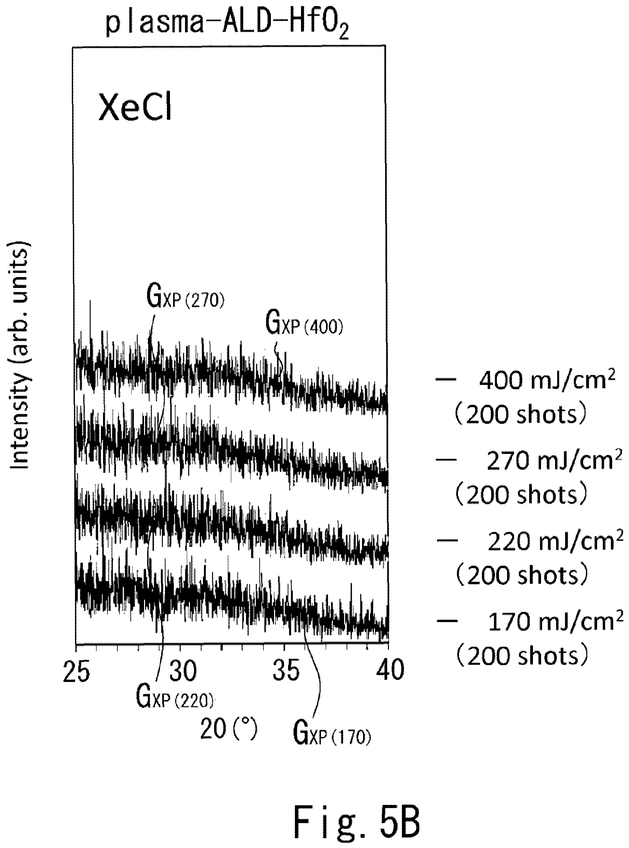

Fig. 5B is a graph showing an X-ray diffraction pattern (result of Experiment 2). In Fig. 5B, the reference numeral G_{XP(170)} represents a graph when the energy density was 170 mJ/cm². The reference numeral G_{XP(220)} represents a graph when the energy density was 220 mJ/cm². The reference numeral G_{XP(270)} represents a graph when the energy density was 270 mJ/cm². The reference numeral G_{XP(400)} represents a graph when the energy density was 400 mJ/cm².

As for the evaluation using an X-ray diffraction apparatus, similarly to Experiment 1, the hafnium oxide film 20_{P+X} (crystal phase) which had been irradiated with the pulsed laser light 30_{X} as describe above was evaluated by using an X-ray diffraction apparatus (X-ray diffraction apparatus manufactured by Rigaku Holdings Corporation). The conditions for the measurement by the X-ray diffraction apparatus is an incident angle ω being 0.4 deg (ω = 0.4 deg).

Referring to Fig. 5B, it can be understood that there is no peak around 2θ, i.e., 30.35° (2θ = 30.35°) in any of the graphs G_{XP(170)}, G_{XP(220)}, G_{XP(270)}, and G_{XP(400)} in Experiment 2.

That is, it can be understood that the hafnium oxide film 20_{P} formed over the silicon substrate 10 cannot be crystallized (modified) into a hafnium oxide film in which the most stable m-phase is suppressed, i.e., into a hafnium oxide film mainly composed of a ferroelectric o-phase, in Experiment 2.

### <Examination on Experiments 1 and 2>

As described above, in both Experiments 1 and 2, no peak appeared around 2θ, i.e., 30.35° (2θ = 30.35°) (see Figs. 5A and 5B). It is considered that this is because of a lack lattice vibrations for advancing the crystallization of the amorphous hafnium oxide film. Therefore, in order to compensate for the lack of lattice vibrations, Experiments 3 to 6 in which a pulsed laser irradiation apparatus equipped with a KrF light source of which the kinetic energy of photons was larger than that of the XeCl light source were carried out.

### <Experiment 3>

Experiment 3 was carried out under the conditions shown in Table 3 shown below.

**[Table 3]**

| | |
|---|---|
| Film Forming | Film Forming Apparatus: ALD Apparatus (Demonstration Machine) manufactured by JSW AFTY Corporation |
| | Film Forming Technique: thermal-ALD (thermal ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: KrF Light Source |
| | Laser Wavelength: 248 nm |
| | Pulse Interval: 10 ms (100 Hz) |
| | Pulse Width (FWHM): Several Tens of Nanoseconds |

Experiment 3 will be described hereinafter in detail.

### <Formation of Film in Experiment 3 >

In Experiment 3, similarly to Experiment 1, an amorphous hafnium oxide film 20_{T} was formed over a silicon substrate 10 by a thermal-ALD method using a film forming apparatus (ALD apparatus (demonstration machine) manufactured by JSW AFTY Corporation).

Specifically, similarly to Experiment 1 (see Fig. 3), an extremely thin hafnium oxide film 20_{T} having a film thickness of 10 nm was formed over a silicon substrate 10, which had been heated to 120°C by a heater in advance, by bringing one of the surfaces of the silicon substrate 10 into contact with a flowing source gas, an oxidizing agent; and an inert gas. Note that tEMAH (Tetrakis(EthylMethylAmido)Hafnium) was used as the source gas; O₃ was used as the oxidizing agent; and N₂ was used as the inert gas.

### <Crystallization (Modifying) in Experiment 3>

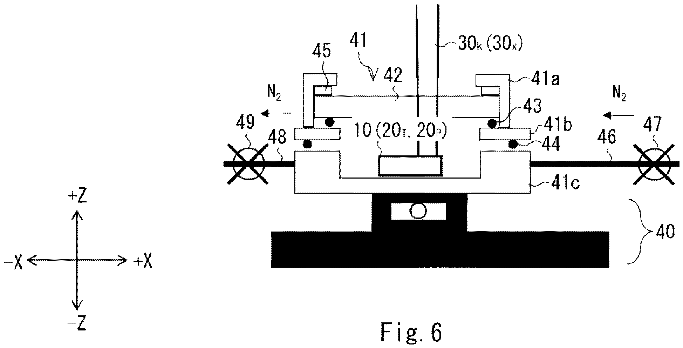

Fig. 6 is a schematic diagram showing how the hafnium oxide film 20_{T} formed over the silicon substrate 10 is crystallized (modified).

In Experiment 3, the hafnium oxide film 20_{T} formed over the silicon substrate 10 was irradiated with pulsed laser light 30_{K} whose wavelength is in an ultraviolet region by using a pulsed laser irradiation apparatus equipped with a KrF light source (wavelength 248 nm) (excimer laser irradiation apparatus (demonstration machine) manufactured by JSW Aktina System Co., Ltd.). The pulsed laser light 30_{K} had a wavelength of 248 nm, a pulse interval of 10 ms (100 Hz), and a pulse width (FWHM) of several tens of nanoseconds, and the number of times of irradiation was one (1shot). In Experiment 3, the energy density of the pulsed laser light 30_{K} was changed to 300 mJ/cm², 350 mJ/cm², 400 mJ/cm², and 450 mJ/cm², and the pulsed laser light 30_{K} was applied once (1shot) with each of these energy densities.

Specifically, as shown in Fig. 6, a silicon substrate 10 (hafnium oxide film 20_{T}) disposed in a chamber 41 which was moved in an X (+X, -X) direction and a Y(+Y, -Y) direction (directions perpendicular to the paper surface in Fig. 6) by a conveyance mechanism 40 was irradiated with pulsed laser light 30_{K} through anhydrous quartz 42 in a nitrogen atmosphere, which was supplied into the chamber 41, by using a pulsed laser irradiation apparatus (excimer laser irradiation apparatus (demonstration machine) manufactured by JSW Aktina System Co., Ltd.). As shown in Fig. 6, the chamber 41 is formed by combining a plurality of chamber components 41a, 41b, 41c, and the like, and is sealed by sealing materials 43 and 44, and a buffer material 45. The buffer material 45 is a Teflon (Registered Trademark) buffer material which is provided in order to prevent direct interference between the anhydrous quartz 42 and the chamber component 41a (made of stainless steel). In Fig. 5, the reference numeral 47 represents a valve provided in a nitrogen supply pipe 46, and the reference numeral 49 represents a valve provided in a nitrogen discharge pipe 48. Nitrogen is supplied into the chamber 41 through the nitrogen supply pipe 46 and discharged to the outside of the chamber 41 through the nitrogen discharge pipe 48.

The size (cross-sectional size) of the pulsed laser light 30_{K} was 3 mm×3 mm. Further, each time the pulsed laser light 30_{K} was applied once (1shot), the chamber 41 was moved so that adjacent regions already irradiated with the pulsed laser light 30 did not overlap one another. Hereinafter, the hafnium oxide film 20_{T} which was formed over the silicon substrate 10 by the thermal-ALD method and irradiated with the pulsed laser light 30_{K} will be referred to as a hafnium oxide film 20_{T+K}.

### <Results of Experiment 3>

Next, the results (evaluation results) of Experiment 3 will be described.

### <Evaluation by X-ray Diffraction Apparatus>

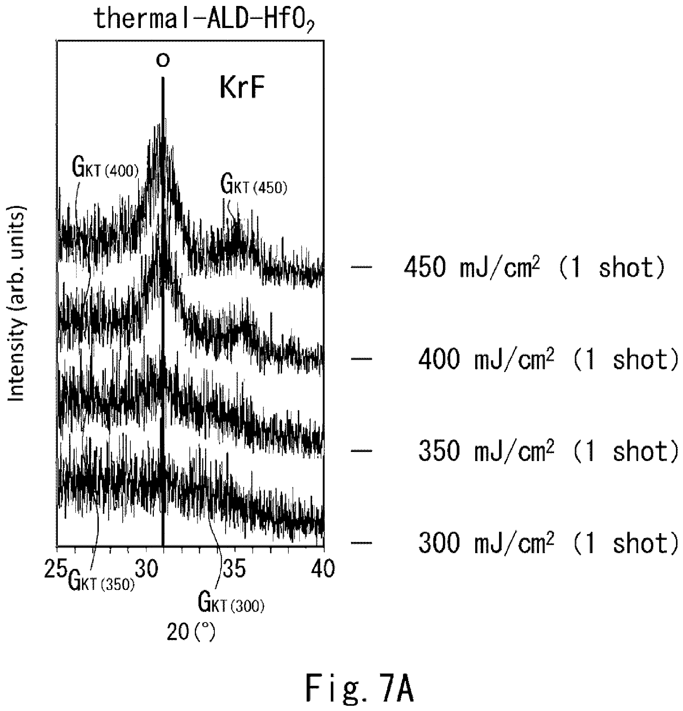

Fig. 7A is a graph showing an X-ray diffraction pattern (result of Experiment 3). In Fig. 7A, the reference numeral G_{KT(300)} represents a graph when the energy density was 300 mJ/cm². The reference numeral G_{KT(350)} represents a graph when the energy density was 350 mJ/cm². The reference numeral G_{KT(400)} represents a graph when the energy density was 400 mJ/cm². The reference numeral G_{KT(450)} represents a graph when the energy density was 450 mJ/cm².

As for the evaluation using an X-ray diffraction apparatus, similarly to Experiment 1, the hafnium oxide film 20_{T+K} (crystal phase) which had been irradiated with the pulsed laser light 30_{K} as describe above was evaluated by using an X-ray diffraction apparatus (X-ray diffraction apparatus manufactured by Rigaku Holdings Corporation). The conditions for the measurement by the X-ray diffraction apparatus is an incident angle ω being 0.4 deg (ω = 0.4 deg).

Referring to Fig. 7A, it can be understood that there is a peak around 2θ, i.e., 30.35° (2θ = 30.35°) in each of the graphs G_{KT(400)} and G_{KT(450)} in Experiment 3.

That is, based on the evaluation by the X-ray diffraction apparatus, it can be understood that in the case of the amorphous hafnium oxide film 20_{T} formed by the thermal-ALD method, it is possible to crystalize (modify) the hafnium oxide film 20_{T} into a hafnium oxide film in which the most stable m-phase is suppressed, i.e., into a hafnium oxide film mainly composed of a ferroelectric o-phase, by selecting pulsed laser light 30_{K} having a wavelength of 248 nm and an energy density of 400 mJ/cm² or higher.

### <Evaluation by SEM>

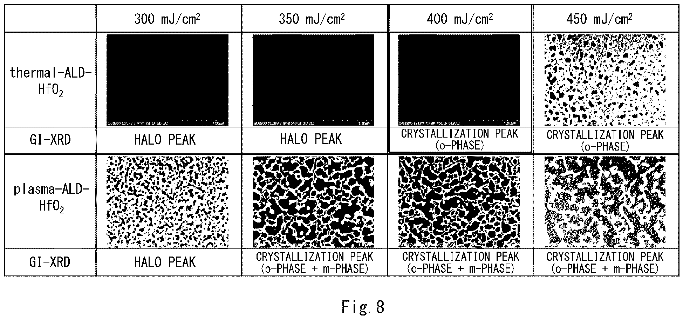

The middle and upper rows in Fig. 8 are SEM images of the hafnium oxide film 20_{T+K} taken by a SEM. SEM is an abbreviation of Scanning Electron Microscope and is also called a scanning electron microscope.

The hafnium oxide film 20_{T+K} (surface shape) was evaluated by using a SEM (scanning electron microscope manufactured by Hitachi High-Tech Corporation). Relatively bright parts in each SEM image represent agglomerated parts (agglomerated parts of hafnium oxide), and relatively dark parts represent parts of the hafnium oxide film where the thickness is small. Based on the element identification in the bright parts, it was found that the agglomeration had advanced. Note that the brightness was not standardized for all the images, so the evaluation was based on the contrast in the SEM image.

Therefore, when the SEM image includes relatively bright parts and relatively dark parts, it can be evaluated that the hafnium oxide film 20_{T+K} is agglomerated. On the other hand, when the SEM image does not include relatively bright parts and relatively dark parts (e.g., when it includes only one of bright parts and dark parts), it can be evaluated that the hafnium oxide film 20_{T+K} is not agglomerated.

Referring to the middle and upper rows in Fig. 8, in the case of the energy density of 450 mJ/cm², the SEM image of the energy density of 450 mJ/cm² includes relatively bright parts and relatively dark parts (there are both parts in a mixed manner). Therefore, in the case of the energy density of 450 mJ/cm², it can be evaluated that the hafnium oxide film 20_{T+K} is agglomerated. The hafnium oxide film 20_{T+K} agglomerated as described above is unsuitable as a ferroelectric material for a nonvolatile memory device because the shape of the hafnium oxide film (mainly, the surface shape of the hafnium oxide film 20_{T} upon the completion of the film formation) is not maintained.

In contrast, in the case of the energy density of 400 mJ/cm², the SEM image of the energy density of 400 mJ/cm² does not include relatively bright parts and relatively dark parts. Therefore, in the case of the energy density of 400 mJ/cm², it can be evaluated that the hafnium oxide film 20_{T+K} is not agglomerated. The hafnium oxide film 20_{T+K} which is not agglomerated as described above is suitable as a ferroelectric material for a nonvolatile memory device because the shape of the hafnium oxide film (mainly, the surface shape of the hafnium oxide film 20_{T} upon the completion of the film formation) is maintained.

As described above, according to Experiment 3, it can be understood that in the case of the amorphous hafnium oxide film 20_{T} formed by the thermal-ALD method, it is possible to crystalize (modify) the hafnium oxide film 20_{T} formed over the silicon substrate 10 into a hafnium oxide film in which the most stable m-phase is suppressed, i.e., into a hafnium oxide film mainly composed of a ferroelectric o-phase, by selecting pulsed laser light 30_{K} having a wavelength of 248 nm and an energy density of 400 mJ/cm² or higher, and in addition, the agglomeration of the hafnium oxide film does not occur.

### <Experiment 4>

Experiment 4 was carried out under the conditions shown in Table 4 shown below.

**[Table 4]**

| | |
|---|---|
| Film Forming | Film Forming Apparatus: ALD Apparatus (Demonstration Machine) manufactured by JSW AFTY Corporation |
| | Film Forming Technique: plasma-ALD (plasma ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: KrF Light Source |
| | Laser Wavelength: 248 nm |
| | Pulse Interval: 10 ms (100 Hz) |
| | Pulse Width (FWHM): Several Tens of Nanoseconds |

Experiment 4 will be described hereinafter in detail.

### <Formation of Film in Experiment 4>

In Experiment 4, similarly to Experiment 2, an amorphous hafnium oxide film 20_{P} was formed over a silicon substrate 10 by a plasma-ALD method using a film forming apparatus (ALD apparatus (demonstration machine) manufactured by JSW AFTY Corporation).

Specifically, similarly to Experiment 1 (see Fig. 3), an extremely thin hafnium oxide film 20_{P} having a film thickness of 10 nm was formed over a silicon substrate 10 (one of the surfaces thereof), which had been heated to 120°C by a heater in advance, by bringing one of the surfaces of the silicon substrate 10 into contact with a flowing source gas, an oxidizing agent; and an inert gas Note that tEMAH (Tetrakis(EthylMethylAmido)Hafnium) was used as the source gas; O₂ plasma was used as the oxidizing agent; and N₂ was used as the inert gas.

### <Crystallization (Modifying) in Experiment 4>

In Experiment 4, similarly to Experiment 3, the hafnium oxide film 20_{P} formed over the silicon substrate 10 was irradiated with pulsed laser light 30_{K} whose wavelength is in an ultraviolet region by using a pulsed laser irradiation apparatus equipped with a KrF light source (wavelength 248 nm) (excimer laser irradiation apparatus (demonstration machine) manufactured by JSW Aktina System Co., Ltd.). The pulsed laser light 30_{K} had a wavelength of 248 nm, a pulse interval of 10 ms (100 Hz), and a pulse width (FWHM) of several tens of nanoseconds, and the number of times of irradiation was one (1shot). In Experiment 4, the energy density of the pulsed laser light 30_{K} was changed to 300 mJ/cm², 350 mJ/cm², 400 mJ/cm², and 450 mJ/cm², and the pulsed laser light 30_{K} was applied once (1shot) with each of these energy densities.

Specifically, similarly to Experiment 3 (see Fig. 6), a silicon substrate 10 (amorphous hafnium oxide film 20) disposed in a chamber 41 which was moved in an X (+X, -X) direction and a Y(+Y, -Y) direction (directions perpendicular to the paper surface in Fig. 6) by a conveyance mechanism 40 was irradiated with pulsed laser light 30_{K} through anhydrous quartz 42 in a nitrogen atmosphere, which was supplied into the chamber 41, by using a pulsed laser irradiation apparatus (excimer laser irradiation apparatus (demonstration machine) manufactured by JSW Aktina System Co., Ltd.).

The size (cross-sectional size) of the pulsed laser light 30_{K} was 3 mm×3 mm. Further, each time the pulsed laser light 30_{K} was applied once (one shot), the chamber 41 was moved so that adjacent regions already irradiated with the pulsed laser light 30 did not overlap one another. Hereinafter, the hafnium oxide film 20_{P} which was formed over the silicon substrate 10 by the plasma-ALD method and irradiated with the pulsed laser light 30_{K} will be referred to as a hafnium oxide film 20_{P+K}.

### <Results of Experiment 4>

Next, the results (evaluation results) of Experiment 4 will be described.

### <Evaluation by X-ray Diffraction Apparatus>

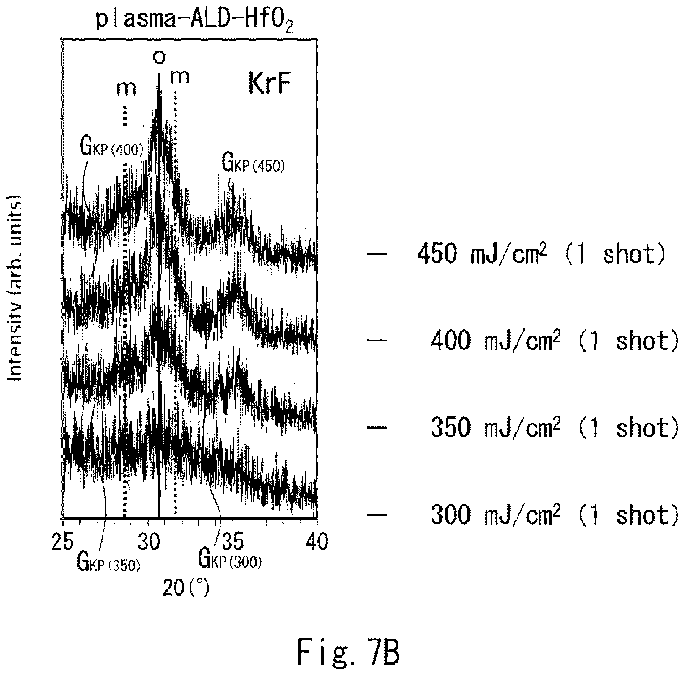

Fig. 7B is a graph showing an X-ray diffraction pattern (result of Experiment 4). In Fig. 7B, the reference numeral G_{KP(300)} represents a graph when the energy density was 300 mJ/cm². The reference numeral G_{KP(350)} represents a graph when the energy density was 350 mJ/cm². The reference numeral G_{KP(400)} represents a graph when the energy density was 400 mJ/cm². The reference numeral G_{KP(450)} represents a graph when the energy density was 450 mJ/cm².

As for the evaluation using an X-ray diffraction apparatus, similarly to Experiment 1, the hafnium oxide film 20_{P+K} (crystal phase) which had been irradiated with the pulsed laser light 30_{K} as describe above was evaluated by using an X-ray diffraction apparatus (X-ray diffraction apparatus manufactured by Rigaku Holdings Corporation). The conditions for the measurement by the X-ray diffraction apparatus is an incident angle ω being 0.4 deg (ω = 0.4 deg).

Referring to Fig. 7B, it can be understood that there is a peak around 2θ, i.e., 30.35° (2θ = 30.35°) in each of the graphs G_{KP(350)}, G_{KP(400)}, and G_{KP(450)} in Experiment 4.

That is, based on the evaluation by the X-ray diffraction apparatus, it can be understood that in the case of the amorphous hafnium oxide film 20_{P} formed by the plasma-ALD method, it is possible to crystalize (modify) the hafnium oxide film 20_{P} into a hafnium oxide film in which the most stable m-phase is suppressed, i.e., into a hafnium oxide film mainly composed of a ferroelectric o-phase, by selecting pulsed laser light 30_{K} having a wavelength of 248 nm and an energy density of 350 mJ/cm² or higher.

### <Evaluation by SEM>

The middle and lower rows in Fig. 8 are SEM images of the hafnium oxide film 20_{P+K} taken by a SEM.

Similarly to Experiment 3, the hafnium oxide film 20_{P+K} (surface shape) was evaluated by using a SEM (scanning electron microscope manufactured by Hitachi High-Tech Corporation).

Referring to the middle and lower rows in Fig. 8, in the case of the energy densities of 300 mJ/cm², 350 mJ/cm², 400 mJ/cm², and 450 mJ/cm², each SEM image includes relatively bright parts and relatively dark parts (there are both parts in a mixed manner). Therefore, in the case of the energy densities of 300 mJ/cm², 350 mJ/cm², 400 mJ/cm², and 450 mJ/cm², it can be evaluated that the hafnium oxide film 20_{P+K} is agglomerated. The hafnium oxide film 20_{P+K} agglomerated as described above is unsuitable as a ferroelectric material for a nonvolatile memory device because the shape of the hafnium oxide film (mainly, the surface shape of the hafnium oxide film 20_{P} upon the completion of the film formation) is not maintained.

As described above, according to Experiment 4, it can be understood that in the case of the amorphous hafnium oxide film 20_{P} formed by the plasma-ALD method, although it is possible to crystalize (modify) the hafnium oxide film 20_{P} formed over the silicon substrate 10 into a hafnium oxide film in which the most stable m-phase is suppressed, i.e., into a hafnium oxide film mainly composed of a ferroelectric o-phase, by selecting pulsed laser light 30_{K} having a wavelength of 248 nm and an energy density of 400 mJ/cm² or higher, the agglomeration of the hafnium oxide film occurs.

### <Examination on Experiments 3 and 4>

Experiments 3 and 4 are both examples in which: a pulsed laser irradiation apparatus equipped with a KrF light source was used; the number of times of irradiation was fixed to once (1shot); and the pulsed laser light 30_{K} of which the energy density was changed was applied. Further, they have a peak around 2θ, i.e., 30.35° (2θ = 30.35°) (see Figs. 7A and 7B).

While the m-phase was completely suppressed in the thermal-ALD (Experiment 3), the crystallization of the m-phase had slightly advanced in the plasma-ALD (Experiment 4) (see Figs. 7A and 7B). It is presumed that this difference in the deposition method is caused by the difference in the density of the film. The density in the plasma-ALD tends to be higher than that in the thermal-ALD. The high density means that lattice vibrations are likely to propagate.

It is inferred that in the thermal-ALD, since the density is relatively low and lattice vibrations are not likely to propagate, the structural change did not reach the m-phase of which the symmetry was low. Conversely, it is inferred that in the plasma-ALD, since the density is relatively high and lattice vibrations are likely to propagate, the structural change reached the m-phase of which the symmetry was low.

Further, while an energy density of 400 mJ/cm² or higher was required for the crystallization in the thermal-ALD (Experiment 3), an energy density of 350 mJ/cm² or higher was required for the crystallization in the plasma-ALD (Experiment 4). It is considered that this difference is also caused by the difference in the density.

In the thermal-ALD (Experiment 3), the crystallization had advanced when the energy density was 400 mJ/cm² or higher, and the m-phase was suppressed. However, as seen in the result of the SEM, the agglomeration started to occur at the energy density of 450 mJ/cm². Meanwhile, in the plasma-ALD (Experiment 4), the crystallization had advanced when the energy density was 350 mJ/cm² or higher, but the agglomeration had already occurred at the energy density of 300 mJ/cm².

Based on the above-described facts, it can be understood that the process in which the agglomeration does not occur, i.e., the crystallization for suppressing the m-phase is feasible while maintaining the shape of the hafnium oxide film (mainly, the surface shape of the hafnium oxide film upon the completion of the film formation), is a film formation technique using the thermal-ALD, and it is necessary to apply pulsed laser light having a wavelength of 248 nm in an ultraviolet region (KrF light source) with an energy density of 400 mJ/cm².

### <Experiment 5>

Experiment 5 was carried out under the conditions shown in Table 5 shown below.

**[Table 5]**

| | |
|---|---|
| Film Forming | Film Forming Apparatus: ALD Apparatus (Demonstration Machine) manufactured by JSW AFTY Corporation |
| | Film Forming Technique: thermal-ALD (thermal ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: KrF Light Source |
| | Laser Wavelength: 248 nm |
| | Pulse Interval: 10 ms (100 Hz) |
| | Pulse Width (FWHM): Several Tens of Nanoseconds |

Experiment 5 will be described hereinafter in detail.

### <Formation of Film in Experiment 5>

In Experiment 5, similarly to Experiment 1, an amorphous hafnium oxide film 20_{T} was formed over a silicon substrate 10 by a thermal-ALD method using a film forming apparatus (ALD apparatus (demonstration machine) manufactured by JSW AFTY Corporation).

Specifically, similarly to Experiment 1 (see Fig. 3), an extremely thin hafnium oxide film 20_{T} having a film thickness of 10 nm was formed over a silicon substrate 10, which had been heated to 120°C by a heater in advance, by bringing one of the surfaces of the silicon substrate 10 into contact with a flowing source gas, an oxidizing agent; and an inert gas. Note that tEMAH (Tetrakis(EthylMethylAmido)Hafnium) was used as the source gas; O₃ was used as the oxidizing agent; and N₂ was used as the inert gas.

### <Crystallization (Modifying) in Experiment 5>

In Experiment 5, similarly to Experiment 3, the hafnium oxide film 20_{T} formed over the silicon substrate 10 was irradiated with pulsed laser light whose wavelength is in an ultraviolet region by using a pulsed laser irradiation apparatus equipped with a KrF light source (wavelength 248 nm) (excimer laser irradiation apparatus (demonstration machine) manufactured by JSW Aktina System Co., Ltd.). The pulsed laser light 30_{K} had a wavelength of 248 nm, a pulse interval of 10 ms (100 Hz), a pulse width (FWHM) of several tens of nanoseconds, and an energy density of 400 mJ/cm². In Experiment 5, the pulse laser light 30_{K} was applied zero times (as-deposition), once (1shot), twice (2 shots), 20 times (20 shots), and 200 times (200 shots).

Specifically, similarly to Experiment 3 (see Fig. 6), a silicon substrate 10 (hafnium oxide film 20_{T}) disposed in a chamber 41 which was moved in an X (+X, -X) direction and a Y(+Y, -Y) direction (directions perpendicular to the paper surface in Fig. 6) by a conveyance mechanism 40 was irradiated with pulsed laser light 30_{K} through anhydrous quartz 42 in a nitrogen atmosphere, which was supplied into the chamber 41, by using a pulsed laser irradiation apparatus (excimer laser irradiation apparatus (demonstration machine) manufactured by JSW Aktina System Co., Ltd.).

The size (cross-sectional size) of the pulsed laser light 30_{K} was 3 mm×3 mm. Further, each time the pulsed laser light 30_{K} was applied a predetermined number of times, the chamber 41 was moved so that adjacent regions already irradiated with the pulsed laser light 30_{K} did not overlap one another. Hereinafter, the hafnium oxide film 20_{T} which was formed over the silicon substrate 10 by the thermal-ALD method and irradiated with the pulsed laser light 30_{K} will be referred to as a hafnium oxide film 20_{T+K}.

### <Results of Experiment 5>

Next, the results (evaluation results) of Experiment 5 will be described.

### <Evaluation by X-ray Diffraction Apparatus>

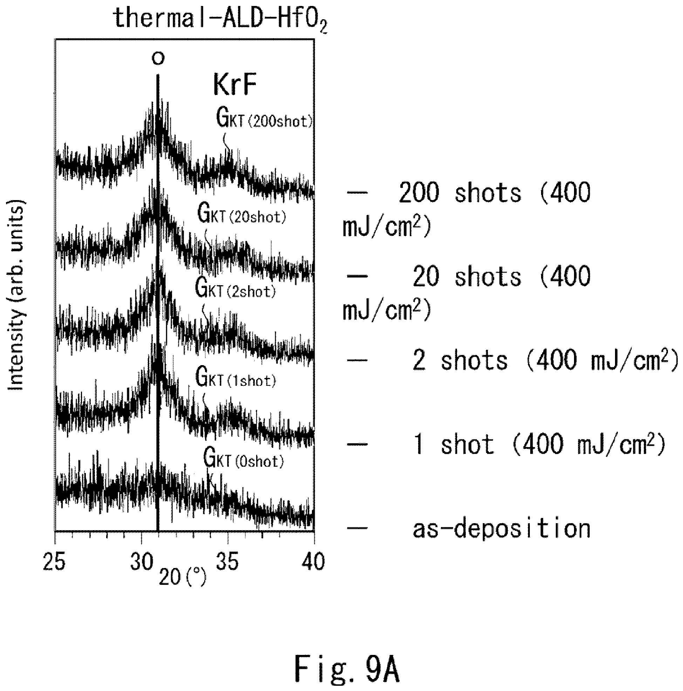

Fig. 9A is a graph showing an X-ray diffraction pattern (result of Experiment 5). In Fig. 9A, the reference numeral G_{KT(0shot)} represents a graph when the number of times of irradiation (number of shots) is zero. The reference numeral G_{KT(1shot)} represents a graph when the number of times of irradiation (number of shots) is one. The reference numeral G_{KT((2shot)} represents a graph when the number of times of irradiation (number of shots) is two. The reference numeral G_{KT(20shot)} represents a graph when the number of times of irradiation (number of shots) is 20. The reference numeral G_{KT(200shot)} represents a graph when the number of times of irradiation (number of shots) is 200.

As for the evaluation using an X-ray diffraction apparatus, similarly to Experiment 1, the hafnium oxide film 20_{T+K} (crystal phase) which had been irradiated with the pulsed laser light 30_{K} as describe above was evaluated by using an X-ray diffraction apparatus (X-ray diffraction apparatus manufactured by Rigaku Holdings Corporation). The conditions for the measurement by the X-ray diffraction apparatus is an incident angle ω being 0.4 deg (ω = 0.4 deg).

Referring to Fig. 9A, it can be understood that there is a peak around 2θ, i.e., 30.35° (2θ = 30.35°) in each of the graphs G_{KT(1shot)}, G_{KT(2shot)}, G_{KT(20shot)}, and G_{KT(200shot)} in Experiment 5.

That is, based on the evaluation by the X-ray diffraction apparatus, it can be understood that in the case of the amorphous hafnium oxide film 20_{T} formed by the thermal-ALD method, it is possible to crystalize (modify) the hafnium oxide film 20_{T} into a hafnium oxide film in which the most stable m-phase is suppressed, i.e., into a hafnium oxide film mainly composed of a ferroelectric o-phase, by selecting pulsed laser light 30_{K} having a wavelength of 248 nm and an energy density of 400 mJ/cm² or higher, and the number of times of irradiation being one or more.

### <Evaluation by SEM>

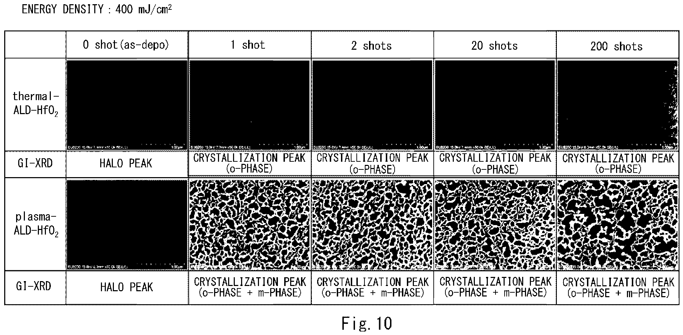

The middle and upper rows in Fig. 10 are SEM images of the hafnium oxide film 20_{T+K} taken by a SEM.

Similarly to Experiment 3, the hafnium oxide film 20_{T+K} (surface shape) was evaluated by using a SEM (scanning electron microscope manufactured by Hitachi High-Tech Corporation).

Referring to the middle and upper rows in Fig. 10, in the case of the energy density of 400 mJ/cm², the SEM image of each of one shot, two shots, 20 shots, and 200 shots does not include relatively bright parts and relatively dark parts. Therefore, in the case of the energy density of 400 mJ/cm², it can be evaluated that the hafnium oxide film 20_{T+K} is not agglomerated as long as the number of times of irradiation is 200 or less. The hafnium oxide film 20_{T+K} which is not agglomerated as described above is suitable as a ferroelectric material for a nonvolatile memory device because the shape of the hafnium oxide film (mainly, the surface shape of the hafnium oxide film 20_{T} upon the completion of the film formation) is maintained.

### <Experiment 6>

Experiment 6 was carried out under the conditions shown in Table 6 shown below.

**[Table 6]**

| | |
|---|---|
| Film Forming | Film Forming Apparatus: ALD Apparatus (Demonstration Machine) manufactured by JSW AFTY Corporation |
| | Film Forming Technique: plasma-ALD (plasma ALD method) |
| | Film Thickness of Amorphous Hafnium Oxide |
| | Film: 10 nm |
| Crystallization (Modifying) | Pulsed Laser Irradiation Apparatus: Excimer Laser Irradiation Apparatus (Demonstration Machine) manufactured by JSW Aktina System Co., Ltd. |
| | Ultraviolet Light Source: KrF Light Source |
| | Laser Wavelength: 248 nm |
| | Pulse Interval: 10 ms (100 Hz) |
| | Pulse Width (FWHM): Several Tens of Nanoseconds |

Experiment 6 will be described hereinafter in detail.

### <Formation of Film in Experiment 6>

In Experiment 6, similarly to Experiment 2, an amorphous hafnium oxide film 20_{P} was formed over a silicon substrate 10 by a plasma-ALD method using a film forming apparatus (ALD apparatus (demonstration machine) manufactured by JSW AFTY Corporation).

Specifically, similarly to Experiment 1 (see Fig. 3), an extremely thin hafnium oxide film 20_{P} having a film thickness of 10 nm was formed over a silicon substrate 10, which had been heated to 120°C by a heater in advance, by bringing one of the surfaces of the silicon substrate 10 into contact with a flowing source gas, an oxidizing agent; and an inert gas Note that tEMAH (Tetrakis(EthylMethylAmido)Hafnium) was used as the source gas; O₂ plasma was used as the oxidizing agent; and N₂ was used as the inert gas.

### <Crystallization (Modifying) in Experiment 6>

In Experiment 6, similarly to Experiment 5, the hafnium oxide film 20_{P} formed over the silicon substrate 10 was irradiated with pulsed laser light whose wavelength is in an ultraviolet region by using a pulsed laser irradiation apparatus equipped with a KrF light source (wavelength 248 nm) (excimer laser irradiation apparatus (demonstration machine) manufactured by JSW Aktina System Co., Ltd.). The pulsed laser light had a wavelength of 248 nm, a pulse interval of 10 ms (100 Hz), a pulse width (FWHM) of several tens of nanoseconds, and an energy density of 400 mJ/cm². In Experiment 6, the pulse laser light 30_{K} was applied zero times (as-deposition), once (1shot), twice (2 shots), 20 times (20 shots), and 200 times (200 shots).

Specifically, similarly to Experiment 5 (see Fig. 6), a silicon substrate 10 (hafnium oxide film 20_{P}) disposed in a chamber 41 which was moved in an X (+X, -X) direction and a Y(+Y, -Y) direction (directions perpendicular to the paper surface in Fig. 6) by a conveyance mechanism 40 was irradiated with pulsed laser light 30_{K} through anhydrous quartz 42 in a nitrogen atmosphere, which was supplied into the chamber 41, by using a pulsed laser irradiation apparatus (excimer laser irradiation apparatus (demonstration machine) manufactured by JSW Aktina System Co., Ltd.).

The size (cross-sectional size) of the pulsed laser light 30_{K} was 3 mm×3 mm. Further, each time the pulsed laser light 30_{K} was applied a predetermined number of times, the chamber 41 was moved so that adjacent regions already irradiated with the pulsed laser light 30_{K} did not overlap one another. Hereinafter, the hafnium oxide film 20_{P} which was formed over the silicon substrate 10 by the plasma-ALD method and irradiated with the pulsed laser light 30_{K} will be referred to as a hafnium oxide film 20_{P+K}.

### <Results of Experiment 6>

Next, the results (evaluation results) of Experiment 6 will be described.

### <Evaluation by X-ray Diffraction Apparatus>

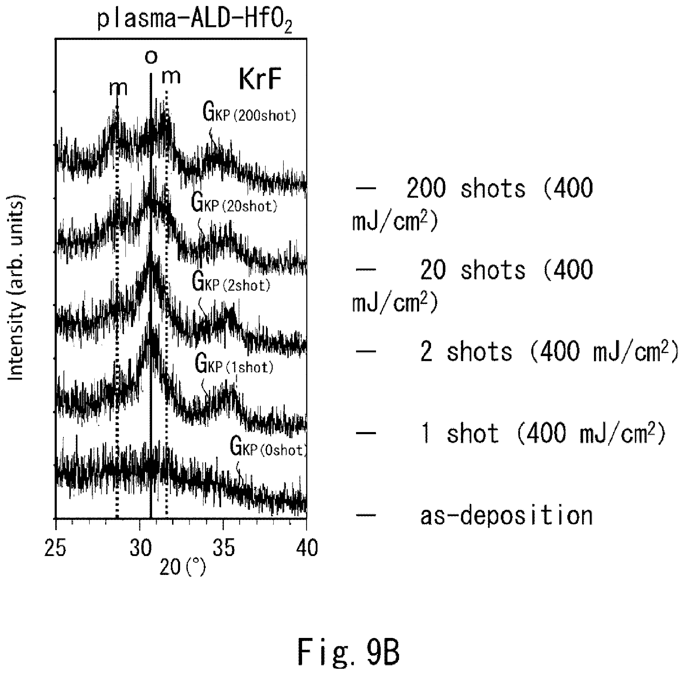

Fig. 9B is a graph showing an X-ray diffraction pattern (result of Experiment 6). In Fig. 9B, the reference numeral G_{KP(0shot)} represents a graph when the number of times of irradiation (number of shots) is zero. The reference numeral G_{KP(1shot)} represents a graph when the number of times of irradiation (number of shots) is one. The reference numeral G_{KP((2shot)} represents a graph when the number of times of irradiation (number of shots) is two. The reference numeral G_{KP(20shot)} represents a graph when the number of times of irradiation (number of shots) is 20. The reference numeral G_{KP(200shot)} represents a graph when the number of times of irradiation (number of shots) is 200.

As for the evaluation using an X-ray diffraction apparatus, similarly to Experiment 3, the hafnium oxide film 20_{P+K} (crystal phase) which had been irradiated with the pulsed laser light 30_{K} as describe above was evaluated by using an X-ray diffraction apparatus (X-ray diffraction apparatus manufactured by Rigaku Holdings Corporation). The conditions for the measurement by the X-ray diffraction apparatus is an incident angle ω being 0.4 deg (ω = 0.4 deg).

Referring to Fig. 9B, it can be understood that there is a peak around 2θ, i.e., 30.35° (2θ = 30.35°) in each of the graphs G_{KP(1shot)}, G_{KP((2shot)}, and G_{KP(20shot)} in Experiment 6.

That is, based on the evaluation by the X-ray diffraction apparatus, it can be understood that in the case of the amorphous hafnium oxide film 20_{P} formed by the plasma-ALD method, it is possible to crystalize (modify) the amorphous hafnium oxide film 20 formed over the silicon substrate 10 into a hafnium oxide film 20_{P} in which the most stable m-phase is suppressed, i.e., into a hafnium oxide film mainly composed of a ferroelectric o-phase, by selecting pulsed laser light 30_{K} having a wavelength of 248 nm and an energy density of 400 mJ/cm² or higher, and the number of times of irradiation being 1 to 20.

### <Evaluation by SEM>

The middle and lower rows in Fig. 10 are SEM images of the hafnium oxide film 20_{P+K} taken by a SEM.

Similarly to Experiment 3, the hafnium oxide film 20_{P+K} (surface shape) irradiated with the above-described pulsed laser light, which was the result of Experiment 5, was evaluated by using a SEM (scanning electron microscope manufactured by Hitachi High-Tech Corporation).

Referring to the middle and lower rows in Fig. 10, in the case of the energy density of 400 mJ/cm², the SEM image of each of one shot, two shots, 20 shots, and 200 shots includes relatively bright parts and relatively dark parts. Therefore, in the case of the energy density of 400 mJ/cm², it can be evaluated that the hafnium oxide film 20_{P+K} has already been agglomerated upon one shot of irradiation (upon the first irradiation). The hafnium oxide film 20_{P+K} agglomerated as described above is unsuitable as a ferroelectric material for a nonvolatile memory device because the shape of the hafnium oxide film (mainly, the surface shape of the hafnium oxide film 20_{P} upon the completion of the film formation) is not maintained.

### <Examination on Experiments 5 and 6>

Experiments 5 and 6 are both examples in which: a pulsed laser irradiation apparatus equipped with a KrF light source was used; the energy density was fixed at 400 mJ/cm²; and the pulsed laser light 30_{K} was applied while changing the number of times of irradiation (number of shots). Further, they have a peak around 2θ, i.e., 30.35° (2θ = 30.35°) (see Figs. 9A and 9B).

In the case of as-deposition, the crystallization did not occur (amorphous) in both the thermal-ALD (Experiment 5) and the plasma-ALD (Experiment 6).

In the case of one shot, the crystallization had advanced and a spectrum in which the o-phase was the dominant phase (being mainly composed of the o-phase) was obtained in both the thermal-ALD (Experiment 5) and the plasma-ALD (Experiment 6). Note that in the case of one shot, a small peak of the m-phase was observed in the plasma-ALD (Experiment 6).

In the thermal-ALD (Experiment 5), the o-phase remained even when the number of times of irradiation was increased to two shots or more.

In contrast, in the case of the plasma-ALD (Experiment 6), when the number of times of irradiation was increased to two shots or more, the peak of the o-phase decreased and the m-phase became the dominant phase (being mainly composed of the m-phase) as the number of times of irradiation increased. The fact that it is dependent on the number of times of irradiation in the plasma-ALD means that the process is different between injecting photons into an amorphous hafnium oxide film and injecting photons into a one-shot hafnium oxide film in which the o-phase is the dominant phase. It is inferred that: even when lattice vibrations were generated from the amorphous hafnium oxide film, the structural change cannot reach the m-phase and the state where the o-phase is the dominant phase remained; however, when lattice vibrations were generated from the o-phase hafnium oxide film, the structural change reaches the m-phase, so that the o-phase was replaced by the m-phase. It is not considered that the o-phase vanishes and the m-phase is generated.

Note that it is presumed that the crystallization of the m-phase did not advance in the thermal-ALD (Experiment 5) because the density was lower than that in the plasma-ALD (Experiment 6), thus making lattice vibrations less likely to propagate.

As for the confirmation in regard to the number of times of irradiation and the surface shape, the agglomeration (agglomeration of hafnium oxide) already occurred upon one shot in the plasma-ALD, so that the agglomeration remained even when the number of times of irradiation was increased. In contrast, the agglomeration did not advance even when the number of times of irradiation was increased in the thermal-ALD.

### <Conditions for Modifying>

Based on Experiments 1 to 6 described above, the conditions for modifying the amorphous hafnium oxide film formed over the silicon substrate 10 (which shows paraelectricity) to the hafnium oxide film mainly composed of the o-phase (which shows ferroelectricity) are as follows.

### (Condition 1)

An amorphous hafnium oxide film 20_{T} is formed over a silicon substrate by a Thermal ALD method. Note that the film thickness of the hafnium oxide film 20_{T} may be set as appropriate according to the required densification level.

### (Condition 2)

The hafnium oxide film 20_{T} formed under the aforementioned Condition 1 is irradiated with pulsed laser light whose wavelength is in an ultraviolet region. When doing so, the energy density, the wavelength, the pulse interval, and the pulse width of the pulsed laser light are selected so that the amorphous hafnium oxide film 20_{T} is modified into a hafnium oxide film 20_{T+K} mainly composed of the o-phase and the agglomeration of the hafnium oxide film 20_{T+K} does not occur. Examples of the energy density, the wavelength, the pulse interval, and the pulse width of the pulsed laser light are an energy density of 400 mJ/cm², a wavelength of 248 nm (e.g., a KrF light source), a pulse interval of 10 ms, and a pulse width of several tens of nanoseconds, respectively. However, they may have other values. Note that it is considered that when CW laser light is used instead of the pulsed laser light, the o-phase does not become the dominant phase, so that the use of the pulsed laser light is essential.

As a guideline for the choices of the energy density, the wavelength, the pulse interval, and the pulse width of the pulsed laser light, it is desirable to select the energy density, the wavelength, the pulse interval, and the pulse width of the pulsed laser light 30_{K} so that the X-ray diffraction pattern of the hafnium oxide film 20_{T+K} obtained by an X-ray diffraction apparatus has a peak around 2θ, i.e., 30.35° (2θ = 30.35°), and the SEM image of the hafnium oxide film 20_{T+K} taken by a scanning electron microscope does not include relatively bright parts and relatively dark parts which are evaluated as the agglomeration of the hafnium oxide film 20_{T+K}.

### <Effects as compared with those in Comparative Example>

Next, effects of embodiments will be described in comparison with those in comparative examples.

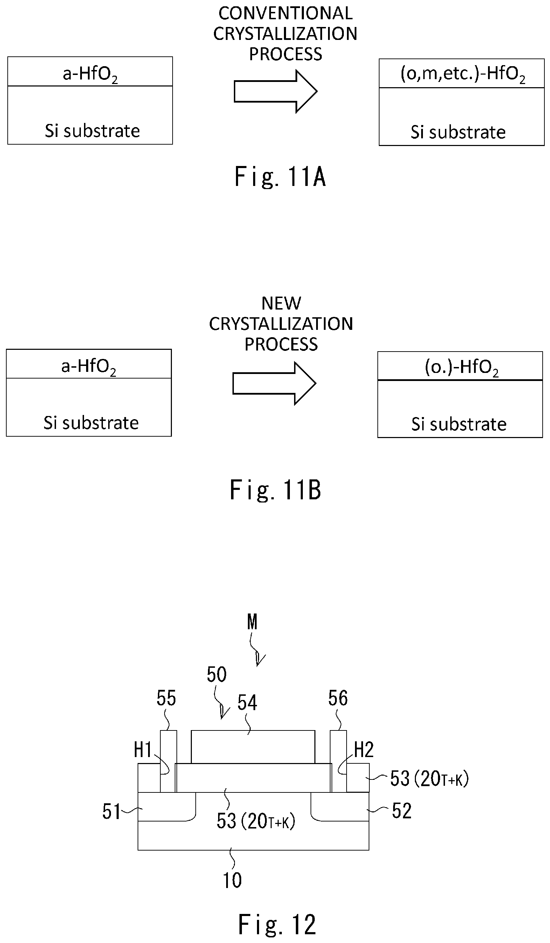

Fig. 11A shows a comparative example, and Fig. 11B shows an embodiment.

In Comparative Example 1, the entire silicon substrate on which a hafnium oxide film is formed is continuously annealed. When the entire silicon substrate on which the hafnium oxide film is formed is continuously annealed, the hafnium oxide film changes into one including a large number of crystal phases including an m-phase and an o-phase as shown in Fig. 11A. "o,m,etc." in Fig. 11A indicates this fact. A hafnium oxide film in which there are a large number of crystal phases in a mixed manner as described above is unsuitable as a ferroelectric material for a nonvolatile memory device.

In contrast, according to the method for modifying a hafnium oxide film according to an embodiment (see, for example, Conditions 1 and 2 shown above), it is possible to crystallize (modify) an amorphous hafnium oxide film 20_{T} formed over a silicon substrate 10 into a hafnium oxide film 20_{T+K} in which the most stable m-phase is suppressed, i.e., into a hafnium oxide film 20_{T+K} mainly composed of a ferroelectric o-phase. (In addition, the agglomeration of the hafnium oxide film 20_{T+K} does not occur.) This hafnium oxide film 20_{T+K} is suitable as a ferroelectric material for a nonvolatile memory device.

### <Nonvolatile Memory Device>

Next, an example of a nonvolatile memory device to which a hafnium oxide film 20_{T+K} modified by the above-described hafnium oxide film modifying method according to the embodiment is applied will be described.

Fig. 12 is a schematic structural diagram of a nonvolatile memory device M to which the hafnium oxide film 20_{T+K} modified by the hafnium oxide film modifying method according to the embodiment is applied.

As shown in Fig. 12, the nonvolatile memory device M includes a silicon substrate 10 and at least one ferroelectric gate transistor 50 formed over the silicon substrate.

The ferroelectric gate transistor 50 includes a source region 51 formed over one of the surfaces of the silicon substrate 10 while being exposed from the one surface, a drain region 52 formed over one of the surfaces of the silicon substrate 10 at a position away from the source region 51 while being exposed from the one surface, a hafnium oxide film 53 mainly composed of an o-phase (hafnium oxide film (20_{T+K}), formed over one of the surfaces of the silicon substrate 10 in such a manner that it covers the source region 51 and the drain region 52, a gate electrode 54 formed over the hafnium oxide film 53, a source electrode 55 electrically connected to the source region 51 through a first contact hole H1 formed in the hafnium oxide film 53 so as to correspond to the source region 51, and a drain electrode 56 inserted into a second contact hole H2, formed in the hafnium oxide film 53 so as to correspond to the drain region 52, and electrically connected to the drain region 52.

Next, an example of a process for manufacturing a nonvolatile memory device M having the above-described structure will be described.

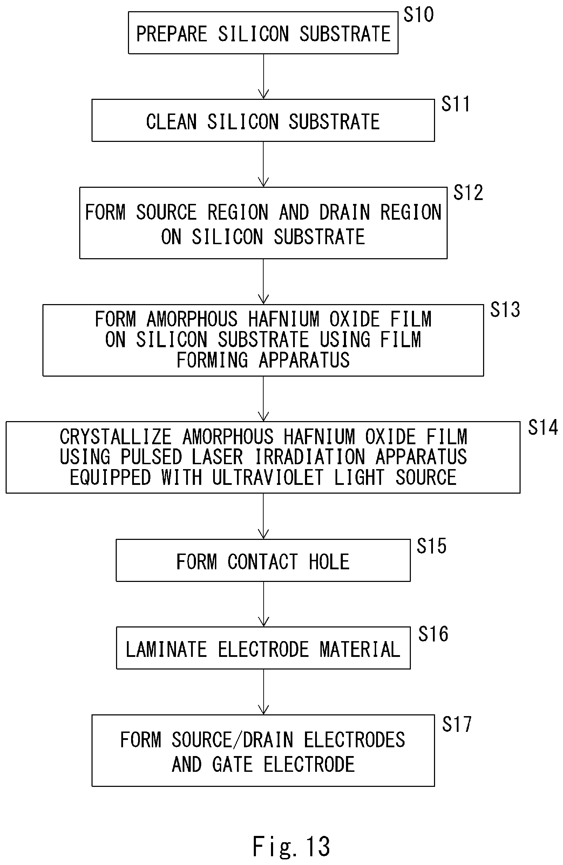

Fig. 13 is an example of a flowchart of a process for manufacturing a nonvolatile memory device M.

Firstly, a silicon substrate 10 is prepared (Step S10) and cleaned (Step S11). The silicon substrate 10 may be, for example, a p-type silicon substrate having a Miller index of (100).

Next, a source region 51 and a drain region 52 are formed over the silicon substrate 10 (Step S12). For example, the source region 51 and the drain region 52 are formed, by performing n-doping, on one of the surfaces of the silicon substrate 10 while being exposed from the one surface. Note that annealing may be performed at this stage, or annealing may be omitted.

Next, an amorphous hafnium oxide film 20_{T} is formed over the silicon substrate 10 by a thermal-ALD method using a film forming apparatus (Step S13). Specifically, the amorphous hafnium oxide film 20_{T} is formed over one of the surfaces of the silicon substrate 10 in such a manner that it covers the source region 51 and the drain region 52. The film thickness of the amorphous hafnium oxide film 20_{T} is, for example, 10 nm.

Next, the amorphous hafnium oxide film 20_{T} is crystallized by using a pulsed laser irradiation apparatus equipped with an ultraviolet light source (e.g., a KrF light source) (Step S14). In this way, the amorphous hafnium oxide film 20_{T} is modified into a hafnium oxide film 53 mainly composed of an o-phase (i.e., into a hafnium oxide film 20_{T+K}).

Next, contact holes H1 and H2 are formed in the hafnium oxide film 53 mainly composed of the o-phase (Step S15).

After that, an electrode material is laminated on the hafnium oxide film 53 mainly composed of the o-phase (Step S16), and a source electrode, a drain electrode, and a gate electrode are formed (Step S17).

Through the series of processes described above, a nonvolatile memory device to which a hafnium oxide film 20_{T+K} modified by the above-described hafnium oxide film modifying method according to the embodiment is applied can be manufactured. Note that the above-described hafnium oxide film modifying method according to the embodiment is not limited to those for the above-described nonvolatile memory device M, and may be applied to nonvolatile memory devices which include a hafnium oxide film but have a different type of structure.

As described above, according to this embodiment, a hafnium oxide (film) mainly composed of a ferroelectric o-phase can be crystallized (modified).

Although the invention made by the inventors of the present application has been described in a concrete manner based on embodiments, needless to say, the present invention is not limited to the embodiments described above, and various modifications can be made without departing from the scope and spirit of the invention.

This application is based upon and claims the benefit of priority from Japanese patent application No. 2024-007913, filed on January 23, 2024, the disclosure of which is incorporated herein in its entirety by reference.

### Reference Signs List

- 10: SILICON SUBSTRATE
- 20: HAFNIUM OXIDE FILM
- 30: PULSED LASER LIGHT
- 40: CONVEYANCE MECHANISM
- 41: CHAMBER
- 42: ANHYDROUS QUARTZ
- 50: FERROELECTRIC GATE TRANSISTOR
- 51: SOURCE REGION
- 52: DRAIN REGION
- 53: HAFNIUM OXIDE FILM
- 54: GATE ELECTRODE
- 55: SOURCE ELECTRODE
- 56: DRAIN ELECTRODE
- A1: REGION ALREADY IRRADIATED WITH PULSED LASER LIGHT
- A2: REGION WHICH HAS NOT YET BE IRRADIATED WITH PULSED LASER LIGHT
- H1: FIRST CONTACT HOLE
- H2: SECOND CONTACT HOLE
- M: NONVOLATILE MEMORY DEVICE

## Claims

1. A method for modifying a hafnium oxide film comprising:
a film forming step of forming an amorphous hafnium oxide film over a silicon substrate; and
a crystallization step of irradiating the amorphous hafnium oxide film with pulsed laser light whose wavelength is in an ultraviolet region in such a manner that the amorphous hafnium oxide film is modified into a hafnium oxide film mainly composed of an o-phase and agglomeration of the hafnium oxide film mainly composed of the o-phase does not occur.

2. The method for modifying a hafnium oxide film according to claim 1, wherein
the amorphous hafnium oxide film is formed by a Thermal ALD method, and
an energy density of the pulsed laser light is 400 mJ/cm² or higher.

3. The method for modifying a hafnium oxide film according to claim 2, wherein: a wavelength of the pulsed laser light is 248 nm; a pulse interval thereof is 10 ms; and a pulse width thereof is several tens of nanoseconds.

4. The method for modifying a hafnium oxide film according to claim 3, wherein the pulsed laser light is emitted from a pulsed laser irradiation apparatus equipped with a KrF light source.

5. The method for modifying a hafnium oxide film according to claim 1, wherein
an X-ray diffraction pattern of the hafnium oxide film modified by the crystallization step, obtained by an X-ray diffraction apparatus has a peak around 2θ, i.e., 30.35° (2θ = 30.35°), and
a SEM image of the hafnium oxide film modified by the crystallization step, taken by a scanning electron microscope does not include a relatively bright part and a relatively dark part which are evaluated as agglomeration of the hafnium oxide film.

6. A nonvolatile memory device comprising a silicon substrate, and a hafnium oxide film formed over the silicon substrate, wherein
the hafnium oxide film is a hafnium oxide film mainly composed of an o-phase, formed by performing:
a film forming step of forming an amorphous hafnium oxide film on the silicon substrate; and
a crystallization step of irradiating the amorphous hafnium oxide film with pulsed laser light whose wavelength is in an ultraviolet region in such a manner that the amorphous hafnium oxide film is modified into a hafnium oxide film mainly composed of an o-phase and agglomeration of the hafnium oxide film mainly composed of the o-phase does not occur.

7. The nonvolatile memory device according to claim 6, comprising:
a source region formed over one of the surfaces of the silicon substrate while being exposed from the one surface;
a drain region formed over one of the surfaces of the silicon substrate at a position away from the source region while being exposed from the one surface;
a gate electrode formed over the hafnium oxide film;
a source electrode electrically connected to the source region through a first contact hole formed in the hafnium oxide film so as to correspond to the source region; and
A drain electrode electrically connected to the drain region through a second contact hole formed in the hafnium oxide film so as to correspond to the drain region, wherein
in the film forming step, an amorphous hafnium oxide film is formed over one of the surfaces of the silicon substrate in such a manner that the amorphous hafnium oxide film covers the source region and the drain region, and
in the crystallization step, the amorphous hafnium oxide film is irradiated with pulsed laser light whose wavelength is in an ultraviolet region in such a manner that the amorphous hafnium oxide film is modified into a hafnium oxide film mainly composed of an o-phase and agglomeration of the hafnium oxide film mainly composed of the o-phase does not occur.
